# EUROPEAN PATENT APPLICATION

(11) **EP 4 391 368 A1**
(43) Date of publication of application: **26.06.2024**
(21) Application number: 23216340.2
(22) Date of filing: 13.12.2023
(51) Int. Cl.: H03D 7/14, H04B 1/28

(54) **RECEIVER HAVING PASSIVE MIXER WITH HIGH-ORDER FILTER**

(30) Priority: 22.12.2022 US 202218145423
(71) Applicant: Apple Inc., Cupertino, CA 95014 (US)
(72) Inventor: GAMBINI, Simone, San Francisco (US)
(74) Representative: COPA Copenhagen Patents

(57) **Abstract**

An electronic device may include a receiver that receives radio-frequency signals using an antenna. The receiver may include a passive voltage mode mixer coupled to a passive second-or-higher order switched-capacitor filter with complex poles. Clocking circuitry may provide a control signal to the filter to cycle the filter through a series of states, may provide first and second local oscillator (LO) signals to the mixer, and may synchronize timing of the control signal with the first and second LO signals. The first and second LO signals may have the same period but may be shifted in time by half the period. The period may be equal to the duration with which the filter is placed in each of the states. The clocking circuitry may pulse the first and second LO signals once while the filter is placed in each of the states.

## Description

This application claims priority to U.S. patent application No. 18/145,423, filed December 22, 2022, which is hereby incorporated by reference herein in its entirety.

### Field

This disclosure relates generally to electronic devices and, more particularly, to electronic devices with wireless communications circuitry.

### Background

Electronic devices are often provided with wireless communications capabilities. An electronic device with wireless communications capabilities has wireless communications circuitry with one or more antennas. Wireless receiver circuitry in the wireless communications circuitry uses the antennas to receive radio-frequency signals.

It can be challenging to form satisfactory receiver circuitry in an electronic device. If care is not taken, the receiver can consume excessive power and the received radio-frequency signals can exhibit excessive noise or aliasing.

### Summary

An electronic device may include wireless circuitry for performing wireless communications. The wireless circuitry may include a transceiver, an antenna, and baseband circuitry. The transceiver may include a receiver that receives radio-frequency signals using the antenna. The receiver may include a passive voltage mode mixer having an input coupled to the antenna. The mixer may downconvert the radio-frequency signals to baseband signals.

The receiver may have a passive second-or-higher order switched-capacitor filter with complex poles. The filter may have an input coupled to the output of the mixer. The filter may filter the baseband signals prior to providing the baseband signals to the baseband circuitry. The filter may include a set of capacitors and a set of butterfly switches interspersed with the set of capacitors. Clocking circuitry may provide a control signal to the butterfly switches that cycles the filter through a series of states. Each state may involve transfer of charge between two of the capacitors with the same polarity or with reverse polarity.

The clocking circuitry may also provide first and second local oscillator (LO) signals to the mixer. The clocking circuitry may synchronize the timing of the control signal provided to the filter with the timing of the first and second LO signals provided to the mixer. For example, the first and second LO signals may have the same period but may be shifted in time by half the period. The period may be equal to the duration with which the filter is placed in each state of the series of states. The clocking circuitry may pulse the first LO signal once and may pulse the second LO signal once while the filter is placed in each state of the series of states (thereby aligning the pulses of the LO signals with pulses of the control signal). Synchronizing the timing of the control signal to the timing of the LO signals may allow the filter to optimize unwanted signal rejection, to minimize aliasing, and/or to minimize noise in the baseband signals provided to the baseband circuitry. Implementing the mixer and the filter using passive components may minimize power consumption without degrading linearity.

An aspect of the disclosure provides a wireless receiver. The wireless receiver can include a mixer having a first transistor with a first gate terminal and having a second transistor with a second gate terminal. The wireless receiver can include clocking circuitry configured to provide a first LO signal to the first gate terminal and a second LO signal to the second gate terminal. The wireless receiver can include a filter coupled to an output of the mixer. The filter can have switching circuitry that is controlled using a control signal to cycle the filter through a series of states. The clocking circuitry can be configured to synchronize the control signal with the first LO signal and the second LO signal.

An aspect of the disclosure provides an electronic device. The electronic device can include an antenna. The electronic device can include a radio-frequency transmission line path coupled to the antenna. The electronic device can include a passive voltage mode mixer having an input coupled to the radio-frequency transmission line path and having an output. The electronic device can include a second-or-higher order passive switched-capacitor filter having an input coupled to the output of the passive voltage mode mixer.

An aspect of the disclosure provides a method of using a wireless receiver to receive radio-frequency signals. The method can include with a passive mixer, downconverting the radio-frequency signals based on a first local oscillator (LO) signal and a second LO signal to generate baseband signals, the second LO signal being offset in time with respect to the first LO signal. The method can include with a passive switched-capacitor filter, filtering the baseband signals based on a control signal that switches the passive switched-capacitor filter between a series of states. The method can include with clocking circuitry, pulsing the first LO signal once while the passive switched-capacitor filter is in each state of the series of states. The method can include with the clocking circuitry, pulsing the second LO signal once while the passive switched-capacitor filter is in each state of the series of states.

### Brief Description of the Drawings

FIG. 1 is a schematic diagram of an illustrative electronic device having wireless circuitry in accordance with some embodiments.
FIG. 2 is a diagram of an illustrative receiver having a passive mixer and a passive high order filter for receiving, downconverting, and filtering radio-frequency signals in accordance with some embodiments.
FIG. 3 is an illustrative timing diagram showing how clocking signals provided to a passive mixer may be synchronized with clocking signals provided to switches in a passive high order filter in accordance with some embodiments.
FIG. 4 is a flow chart of illustrative operations involved in using a receiver having a passive mixer and a passive high order filter to receive radio-frequency signals in accordance with some embodiments.
FIG. 5 is a plot showing how an illustrative receiver with a passive mixer and a passive high order filter can boost signal rejection at certain frequencies in accordance with some embodiments.

### Detailed Description

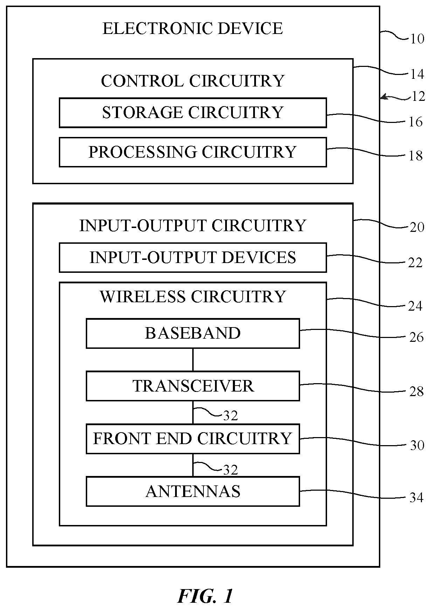

Electronic device 10 of FIG. 1 may be a computing device such as a laptop computer, a desktop computer, a computer monitor containing an embedded computer, a tablet computer, a cellular telephone, a media player, or other handheld or portable electronic device, a smaller device such as a wristwatch device, a pendant device, a headphone or earpiece device, a device embedded in eyeglasses or other equipment worn on a user's head, or other wearable or miniature device, a television, a computer display that does not contain an embedded computer, a gaming device, a navigation device, an embedded system such as a system in which electronic equipment with a display is mounted in a kiosk or automobile, a wireless internet-connected voice-controlled speaker, a home entertainment device, a remote control device, a gaming controller, a peripheral user input device, a wireless base station or access point, equipment that implements the functionality of two or more of these devices, or other electronic equipment.

As shown in the schematic diagram FIG. 1, device 10 may include components located on or within an electronic device housing such as housing 12. Housing 12, which may sometimes be referred to as a case, may be formed of plastic, glass, ceramics, fiber composites, metal (e.g., stainless steel, aluminum, metal alloys, etc.), other suitable materials, or a combination of these materials. In some situations, part or all of housing 12 may be formed from dielectric or other low-conductivity material (e.g., glass, ceramic, plastic, sapphire, etc.). In other situations, housing 12 or at least some of the structures that make up housing 12 may be formed from metal elements.

Device 10 may include control circuitry 14. Control circuitry 14 may include storage such as storage circuitry 16. Storage circuitry 16 may include hard disk drive storage, nonvolatile memory (e.g., flash memory or other electrically-programmable-read-only memory configured to form a solid-state drive), volatile memory (e.g., static or dynamic random-access-memory), etc. Storage circuitry 16 may include storage that is integrated within device 10 and/or removable storage media.

Control circuitry 14 may include processing circuitry such as processing circuitry 18. Processing circuitry 18 may be used to control the operation of device 10. Processing circuitry 18 may include on one or more processors such as microprocessors, microcontrollers, digital signal processors, host processors, baseband processor integrated circuits, application specific integrated circuits, central processing units (CPUs), graphics processing units (GPUs), etc. Control circuitry 14 may be configured to perform operations in device 10 using hardware (e.g., dedicated hardware or circuitry), firmware, and/or software. Software code for performing operations in device 10 may be stored on storage circuitry 16 (e.g., storage circuitry 16 may include non-transitory (tangible) computer readable storage media that stores the software code). The software code may sometimes be referred to as program instructions, software, data, instructions, or code. Software code stored on storage circuitry 16 may be executed by processing circuitry 18.

Control circuitry 14 may be used to run software on device 10 such as satellite navigation applications, internet browsing applications, voice-over-internet-protocol (VOIP) telephone call applications, email applications, media playback applications, operating system functions, etc. To support interactions with external equipment, control circuitry 14 may be used in implementing communications protocols. Communications protocols that may be implemented using control circuitry 14 include internet protocols, wireless local area network (WLAN) protocols (e.g., IEEE 802.11 protocols - sometimes referred to as Wi-Fi^{®}), protocols for other short-range wireless communications links such as the Bluetooth^{®} protocol or other wireless personal area network (WPAN) protocols, IEEE 802.11ad protocols (e.g., ultra-wideband protocols), cellular telephone protocols (e.g., 3G protocols, 4G (LTE) protocols, 3GPP Fifth Generation (5G) New Radio (NR) protocols, Sixth Generation (6G) protocols, sub-THz protocols, THz protocols, etc.), antenna diversity protocols, satellite navigation system protocols (e.g., global positioning system (GPS) protocols, global navigation satellite system (GLONASS) protocols, etc.), antenna-based spatial ranging protocols, optical communications protocols, or any other desired communications protocols. Each communications protocol may be associated with a corresponding radio access technology (RAT) that specifies the physical connection methodology used in implementing the protocol.

Device 10 may include input-output circuitry 20. Input-output circuitry 20 may include input-output devices 22. Input-output devices 22 may be used to allow data to be supplied to device 10 and to allow data to be provided from device 10 to external devices. Input-output devices 22 may include user interface devices, data port devices, and other input-output components. For example, input-output devices 22 may include touch sensors, displays, light-emitting components such as displays without touch sensor capabilities, buttons (mechanical, capacitive, optical, etc.), scrolling wheels, touch pads, key pads, keyboards, microphones, cameras, buttons, speakers, status indicators, audio jacks and other audio port components, digital data port devices, motion sensors (accelerometers, gyroscopes, and/or compasses that detect motion), capacitance sensors, proximity sensors, magnetic sensors, force sensors (e.g., force sensors coupled to a display to detect pressure applied to the display), etc. In some configurations, keyboards, headphones, displays, pointing devices such as trackpads, mice, and joysticks, and other input-output devices may be coupled to device 10 using wired or wireless connections (e.g., some of input-output devices 22 may be peripherals that are coupled to a main processing unit or other portion of device 10 via a wired or wireless link).

Input-output circuitry 20 may include wireless circuitry 24 to support wireless communications. Wireless circuitry 24 (sometimes referred to herein as wireless communications circuitry 24) may include baseband circuitry such as baseband circuitry 26 (e.g., one or more baseband processors and/or other circuitry that operates at baseband), radio-frequency (RF) transceiver circuitry such as transceiver 28, radio-frequency front end circuitry such as front end circuitry 30, and one or more antennas 34. If desired, wireless circuitry 24 may include multiple antennas 34 that are arranged into a phased antenna array (sometimes referred to as a phased array antenna) that conveys radio-frequency signals within a corresponding signal beam that can be steered in different directions. Baseband circuitry 26 may be coupled to transceiver 28 over one or more baseband data paths. Baseband circuitry 26 may include, for example, modulators (encoders) and demodulators (decoders) that operate on baseband signals. Transceiver 28 may be coupled to antennas 34 over one or more radio-frequency transmission line paths 32. Front end circuitry 30 may be disposed on radio-frequency transmission line path(s) 32 between transceiver 28 and antennas 34.

In the example of FIG. 1, wireless circuitry 24 is illustrated as including only a single transceiver 28 and a single radio-frequency transmission line path 32 for the sake of clarity. In general, wireless circuitry 24 may include any desired number of transceivers 28, any desired number of radio-frequency transmission line paths 32, and any desired number of antennas 34. Each transceiver 28 may be coupled to one or more antennas 34 over respective radio-frequency transmission line paths 32. Each radio-frequency transmission line path 32 may have respective front end circuitry 30 disposed thereon. If desired, front end circuitry 30 may be shared by multiple radio-frequency transmission line paths 32.

Radio-frequency transmission line path 32 may be coupled to antenna feeds on one or more antenna 34. Each antenna feed may, for example, include a positive antenna feed terminal and a ground antenna feed terminal. Radio-frequency transmission line path 32 may have a positive transmission line signal path that is coupled to the positive antenna feed terminal and may have a ground transmission line signal path that is coupled to the ground antenna feed terminal. This example is merely illustrative and, in general, antennas 34 may be fed using any desired antenna feeding scheme.

Radio-frequency transmission line path 32 may include transmission lines that are used to route radio-frequency antenna signals within device 10. Transmission lines in device 10 may include coaxial cables, microstrip transmission lines, stripline transmission lines, edge-coupled microstrip transmission lines, edge-coupled stripline transmission lines, transmission lines formed from combinations of transmission lines of these types, etc. Transmission lines in device 10 such as transmission lines in radio-frequency transmission line path 32 may be integrated into rigid and/or flexible printed circuit boards. In one embodiment, radio-frequency transmission line paths such as radio-frequency transmission line path 32 may also include transmission line conductors integrated within multilayer laminated structures (e.g., layers of a conductive material such as copper and a dielectric material such as a resin that are laminated together without intervening adhesive). The multilayer laminated structures may, if desired, be folded or bent in multiple dimensions (e.g., two or three dimensions) and may maintain a bent or folded shape after bending (e.g., the multilayer laminated structures may be folded into a particular three-dimensional shape to route around other device components and may be rigid enough to hold its shape after folding without being held in place by stiffeners or other structures). All of the multiple layers of the laminated structures may be batch laminated together (e.g., in a single pressing process) without adhesive (e.g., as opposed to performing multiple pressing processes to laminate multiple layers together with adhesive).

In performing wireless transmission, baseband circuitry 26 may provide baseband signals to transceiver 28. Transceiver 28 (e.g., one or more transmitters in transceiver 28) may include circuitry for converting the baseband signals received from baseband circuitry 26 into corresponding radio-frequency signals. For example, transceiver 28 may include mixer circuitry for up-converting the baseband signals to radio frequencies prior to transmission over antennas 34. Transceiver 28 may also include digital to analog converter (DAC) and/or analog to digital converter (ADC) circuitry for converting signals between digital and analog domains. Transceiver 28 may transmit the radio-frequency signals over antennas 34 via radio-frequency transmission line path 32 and front end circuitry 30. Antennas 34 may transmit the radio-frequency signals to external wireless equipment by radiating the radio-frequency signals into free space.

In performing wireless reception, antennas 34 may receive radio-frequency signals from the external wireless equipment. The received radio-frequency signals may be conveyed to transceiver 28 via radio-frequency transmission line path 32 and front end circuitry 30. Transceiver 28 may include circuitry for converting the received radio-frequency signals into corresponding baseband signals. For example, transceiver 28 may include one or more receivers having mixer circuitry for down-converting the received radio-frequency signals to baseband frequencies prior to conveying the baseband signals to baseband circuitry 26.

Front end circuitry 30 may include radio-frequency front end components that operate on radio-frequency signals conveyed over radio-frequency transmission line path 32. If desired, the radio-frequency front end components may be formed within one or more radio-frequency front end modules (FEMs). Each FEM may include a common substrate such as a printed circuit board substrate for each of the radio-frequency front end components in the FEM. The radio-frequency front end components in front end circuitry 30 may include switching circuitry (e.g., one or more radio-frequency switches), radio-frequency filter circuitry (e.g., low pass filters, high pass filters, notch filters, band pass filters, multiplexing circuitry, duplexer circuitry, diplexer circuitry, triplexer circuitry, etc.), impedance matching circuitry (e.g., circuitry that helps to match the impedance of antennas 34 to the impedance of radio-frequency transmission line path 32), antenna tuning circuitry (e.g., networks of capacitors, resistors, inductors, and/or switches that adjust the frequency response of antennas 34), radio-frequency amplifier circuitry (e.g., power amplifier circuitry and/or low-noise amplifier circuitry), radio-frequency coupler circuitry, charge pump circuitry, power management circuitry, digital control and interface circuitry, and/or any other desired circuitry that operates on the radio-frequency signals transmitted and/or received by antennas 34.

While control circuitry 14 is shown separately from wireless circuitry 24 in the example of FIG. 1 for the sake of clarity, wireless circuitry 24 may include processing circuitry that forms a part of processing circuitry 18 and/or storage circuitry that forms a part of storage circuitry 16 of control circuitry 14 (e.g., portions of control circuitry 14 may be implemented on wireless circuitry 24). As an example, baseband circuitry 26 and/or portions of transceiver 28 (e.g., a host processor on transceiver 28) may form a part of control circuitry 14.

Wireless circuitry 24 may transmit and/or receive wireless signals within corresponding frequency bands of the electromagnetic spectrum (sometimes referred to herein as communications bands or simply as "bands"). The frequency bands handled by wireless circuitry 24 may include wireless local area network (WLAN) frequency bands (e.g., Wi-Fi^{®} (IEEE 802.11) or other WLAN communications bands) such as a 2.4 GHz WLAN band (e.g., from 2400 to 2480 MHz), a 5 GHz WLAN band (e.g., from 5180 to 5825 MHz), a Wi-Fi^{®} 6E band (e.g., from 5925-7125 MHz), and/or other Wi-Fi^{®} bands (e.g., from 1875-5160 MHz), wireless personal area network (WPAN) frequency bands such as the 2.4 GHz Bluetooth^{®} band or other WPAN communications bands, cellular telephone frequency bands (e.g., bands from about 600 MHz to about 5 GHz, 3G bands, 4G LTE bands, 5G New Radio Frequency Range 1 (FR1) bands below 10 GHz, 5GNew Radio Frequency Range 2 (FR2) bands between 20 and 60 GHz, etc.), other centimeter or millimeter wave frequency bands between 10-100 GHz, near-field communications (NFC) frequency bands (e.g., at 13.56 MHz), satellite navigation frequency bands (e.g., a GPS band from 1565 to 1610 MHz, a Global Navigation Satellite System (GLONASS) band, a BeiDou Navigation Satellite System (BDS) band, etc.), ultra-wideband (UWB) frequency bands that operate under the IEEE 802.15.4 protocol and/or other ultra-wideband communications protocols, communications bands under the family of 3GPP wireless communications standards, communications bands under the IEEE 802.XX family of standards, and/or any other desired frequency bands of interest.

Antennas 34 may be formed using any desired antenna structures. For example, antennas 34 may include antennas with resonating elements that are formed from loop antenna structures, patch antenna structures, inverted-F antenna structures, slot antenna structures, planar inverted-F antenna structures, helical antenna structures, monopole antennas, dipoles, hybrids of these designs, etc. Parasitic elements may be included in antennas 34 to adjust antenna performance.

Filter circuitry, switching circuitry, impedance matching circuitry, and other circuitry may be interposed within radio-frequency transmission line path 32, may be incorporated into front end circuitry 30, and/or may be incorporated into antennas 34 (e.g., to support antenna tuning, to support operation in desired frequency bands, etc.). These components, sometimes referred to herein as antenna tuning components, may be adjusted (e.g., using control circuitry 14) to adjust the frequency response and wireless performance of antennas 34 over time.

In general, transceiver 28 may cover (handle) any suitable communications (frequency) bands of interest. The transceiver may convey radio-frequency signals using antennas 34 (e.g., antennas 34 may convey the radio-frequency signals for the transceiver circuitry). The term "convey radio-frequency signals" as used herein means the transmission and/or reception of the radio-frequency signals (e.g., for performing unidirectional and/or bidirectional wireless communications with external wireless communications equipment). Antennas 34 may transmit the radio-frequency signals by radiating the radio-frequency signals into free space (or to free space through intervening device structures such as a dielectric cover layer). Antennas 34 may additionally or alternatively receive the radio-frequency signals from free space (e.g., through intervening devices structures such as a dielectric cover layer). The transmission and reception of radio-frequency signals by antennas 34 each involve the excitation or resonance of antenna currents on an antenna resonating element in the antenna by the radio-frequency signals within the frequency band(s) of operation of the antennas.

In example where multiple antennas 34 are arranged in a phased antenna array, each antenna 34 may form a respective antenna element of the phased antenna array. Conveying radio-frequency signals using the phased antenna array may allow for greater peak signal gain relative to scenarios where individual antennas 34 are used to convey radio-frequency signals. In satellite navigation system links, cellular telephone links, and other long-range links, radio-frequency signals are typically used to convey data over thousands of feet or miles. In Wi-Fi^{®} and Bluetooth^{®} links at 2.4 and 5 GHz and other short-range wireless links, radio-frequency signals are typically used to convey data over tens or hundreds of feet. In scenarios where millimeter or centimeter wave frequencies are used to convey radio-frequency signals, a phased antenna array may convey radio-frequency signals over short distances that travel over a line-of-sight path. To enhance signal reception for millimeter and centimeter wave communications, the phased antenna array may convey radio-frequency signals using beam steering techniques (e.g., schemes in which antenna signal phase and/or magnitude for each antenna in an array are adjusted to perform beam steering).

For example, each antenna 34 in the phased antenna array may be coupled to a corresponding phase and magnitude controller in front end circuitry 30. The phase and magnitude controllers may adjust the relative phases and/or magnitudes of the radio-frequency signals that are conveyed by each of the antennas 34 in the phased antenna array. The wireless signals that are transmitted or received by the phased antenna array in a particular direction may collectively form a corresponding signal beam. The signal beam may exhibit a peak gain that is oriented in a particular pointing direction at a corresponding pointing angle (e.g., based on constructive and destructive interference from the combination of signals from each antenna in the phased antenna array). Control circuitry 14 may adjust the phase and magnitude controllers to change the direction of the signal beam over time (e.g., to allow device 10 to continue to communicate with external equipment even if the external equipment moves relative to device 10 over time). This example is merely illustrative and, in general, antennas 34 need not be arranged in a phased antenna array.

If desired, one or more receivers in transceiver 28 may include mixer circuitry for downconverting radio-frequency signals to baseband and may include filter circuitry coupled to the output of the mixer circuitry. The filter circuitry may be used to filter undesirable frequencies from the baseband signals prior to passing the baseband signals to baseband circuitry 26. Such undesirable frequencies may be produced by blocker (e.g., aggressor or interferer) signals produced by other components in device 10, external devices, and/or any other signal sources that produce power at or around the frequency of the received radio-frequency signals which, in the absence of the filter circuitry, could otherwise interfere with the proper reception or decoding (demodulation) of the baseband signals by baseband circuitry 26.

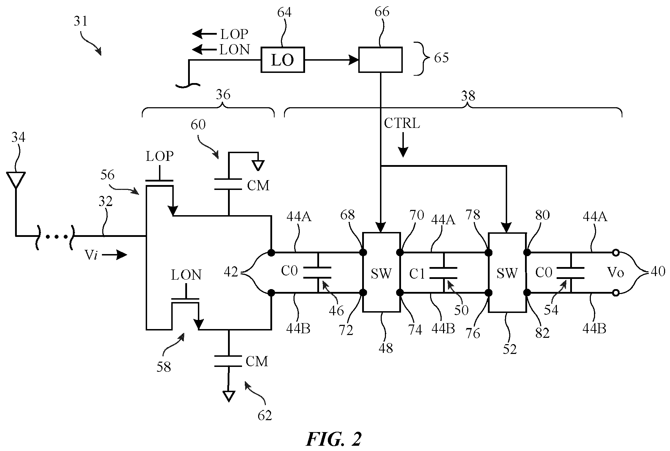

FIG. 2 is a circuit diagram of an illustrative wireless receiver 31 in transceiver 28 that includes mixer circuitry and filter circuitry. As shown in FIG. 2, receiver 31 may include mixer circuitry such as mixer 36 and may include filter circuitry such as filter 38. While a single mixer 36 is shown in FIG. 2 for the sake of clarity, in general mixer 36 may include a pair of mixers (e.g., in-phase (I) and quadrature-phase (Q)) mixers for downconverting signals received over I/Q paths. The input of mixer 36 may be coupled to antenna 34 over radio-frequency transmission line path 32. Mixer 36 may have an output with output terminals 42 coupled to filter 38. The input of filter 38 may be coupled to output terminals 42 of mixer 36. Filter 38 may have an output with output terminals 40. Output terminals 40 may be coupled to baseband circuitry 26 (FIG. 1).

To minimize the cost and power consumption of receiver 31, mixer 36 may be implemented as a passive mixer (e.g., using passive circuitry without amplifiers, buffers, gain or isolation stages, etc.). In the example of FIG. 2, mixer 36 is a passive voltage mode mixer. Mixer 36 may therefore sometimes be referred to herein as passive mixer 36, voltage mode mixer 36, or passive voltage mode mixer 36.

As shown in FIG. 2, mixer 36 may have an input (e.g., an input terminal) coupled to radio-frequency transmission line path 32. Mixer 36 may include a first transistor 56 having a first source/drain terminal coupled to radio-frequency transmission line path 32 (e.g., the input terminal of mixer 36) and having a second source/drain terminal coupled to a first output terminal 42 of mixer 36. Mixer 36 may include a second transistor 58 having a first source/drain terminal coupled to radio-frequency transmission line path 32 (e.g., the input terminal of mixer 36) and a second source/drain terminal coupled to a second output terminal 42 of mixer 36. In this way, transistor 58 may be coupled between the input of mixer 36 and the output of mixer 36 in parallel with transistor 56.

Mixer 36 may include a first capacitor 60 coupled between the second source/drain terminal of transistor 56, the first output terminal 42, and ground or another reference potential. Mixer 36 may also include a second capacitor 62 coupled between the second source/drain terminal of transistor 58, the second output terminal 42, and ground or another reference potential. Capacitors 60 and 62 may each have capacitance CM, for example.

Receiver 31 may include clocking circuitry such as local oscillator (LO) generator 64. LO generator 64 may generate clocking signals such as at least a first local oscillator (LO) signal LOP and a second LO signal LON. In some implementations that are described herein as an example, LO signal LON may be a time-delayed or phase-shifted version of LO signal LOP (e.g., LO generator 64 may include delay circuitry or phase shifter circuitry that generates LO signal LON based on LO signal LOP). LO signal LON may, for example, have the same period (frequency) as LO signal LOP but may be time-delayed or phase-shifted such that LO signal LON is at a logic low level whenever LO signal LOP is at a logic high level and vice versa.

LO generator 64 may provide LO signal LOP to the gate terminal of transistor 56. LO generator 64 may provide LO signal LON to the gate terminal of transistor 58. During signal reception, mixer 36 may receive radio-frequency signals from antenna 34 over radio-frequency transmission line path 32. The received radio-frequency signals may be represented by input voltage Vᵢ, which is at a radio frequency f_{RF}. LO signal LOP may be periodically pulsed at the gate terminal of transistor 56, moving charge from the input of mixer 36 onto capacitor 60. LO signal LON may also be periodically pulsed at the gate terminal of transistor 58 (e.g., in sequence with LO signal LON), moving charge onto capacitor 62. By controlling the timing (e.g., frequency f_{LO}) of LO signals LON and LOP, the clocking circuitry may control mixer 36 to downconvert the radio-frequency signals received at the input of mixer 36 to a baseband frequency f_{BB} at output terminals 42.

In implementations where mixer 36 is an active (non-passive) mixer or a passive mixer, an active buffer/isolation stage may be disposed at output terminals 42 to help provide suitable isolation. In the example of FIG. 2, the input of filter 38 is directly connected to output terminals 42 (and capacitors 60 and 62) without any intervening active circuitry, amplifiers, buffers, etc. This allows mixer 36 to downconvert the received radio-frequency signals while consuming less power and while introducing less linearity degradation than in implementations where the mixer includes an active buffer/isolation stage. However, in general, mixer 36 as described herein may be replaced with an active mixer coupled to a passive switched capacitor filter such as filter 38 (e.g., the filtering techniques described herein may be applied to implementations where mixer 36 is an active mixer if desired).

While capacitors 60 and 62 can introduce capacitive impedances that perform first order filtering for the downconverted (baseband) signals, higher order filtering may be needed to sufficiently remove blocker signals or other undesirable interference sources from the baseband signals prior to providing the baseband signals to baseband circuitry 26 (FIG. 1). In some implementations, additional resistive and capacitive components may be coupled to output terminals 42 to help further filter the signals (e.g., to introduce a second order transfer function to the signals). However, such components are limited to real poles and do not exhibit the complex poles required to optimize filtering of the signals.

As such, filter 38 may be a passive, high order filter (e.g., a filter that is not limited to first order filtering and that exhibits a second order or higher transfer function) with complex poles. In the example of FIG. 2, filter 38 is a passive, second order, switched-capacitor filter having complex poles. Filter 38 may therefore sometimes be referred to herein as passive filter 38, second order filter 38, high order filter 38, complex high order filter 38, passive complex high order filter 38, passive high order filter 38, switched-capacitor filter 38, passive switched-capacitor filter 38, high order switched-capacitor filter 38, passive high order switched-capacitor filter 38, complex switched-capacitor filter 38, or passive complex switched-capacitor filter 38.

As shown in FIG. 2, filter 38 may include parallel conductive (signal) lines 44 coupled between output terminals 42 of mixer 36 and output terminals 40 of filter 38. Lines 44 may include a first line 44A and a second line 44B. Line 44A may be coupled between the first output terminal 42 of mixer 36 and a first output terminal 40 of filter 38. Line 44B may be coupled between the second output terminal 42 of mixer 36 and a second output terminal 40 of filter 38.

Filter 38 may include switching circuitry such as a first switch (SW) 48 disposed on lines 44A and 44B and a second switch (SW) 52 disposed on lines 44A and 44B. Switches 48 and 52 may sometimes be referred to herein as switching networks or switching circuits. Switch 48 may have terminals (ports) 68, 70, 72, and 74. Switch 52 may have terminals (ports) 78, 80, 76, and 82. Terminal 68 may be coupled to the first output terminal 42 of mixer 36 (e.g., a first input terminal of filter 38) over a corresponding portion of line 44A. Terminal 70 of switch 48 may be coupled to terminal 78 of switch 52 over a corresponding portion of line 44A. Terminal 80 may be coupled to the first output terminal 40 of filter 38. Terminal 72 may be coupled to the second output terminal 42 of mixer 36 (e.g., a second input terminal of filter 38) over a corresponding portion of line 44B. Terminal 74 of switch 48 may be coupled to terminal 76 of switch 52 over a corresponding portion of line 44A. Terminal 82 may be coupled to the second output terminal 40 of filter 38.

Filter 38 may also include capacitors coupled between lines 44A and 44B before, between, and after switches 48 and 52. For example, as shown in FIG. 2, filter 38 may include a first capacitor 46 that couples line 44A to line 44B between the output of mixer 36 and the input of switch 48 (e.g., capacitor 46 may have a first electrode or plate coupled to line 44A and a second electrode or plate coupled to line 44B, such that capacitor 46 is coupled between terminals 68 and 72 of switch 48). Capacitor 46 may have a corresponding capacitance C0.

Filter 38 may also include a second capacitor 50 that couples line 44A to line 44B between the output of switch 48 and the input of switch 52 (e.g., capacitor 50 may have a first electrode or plate coupled to line 44A and a second electrode or plate coupled to line 44B, such that capacitor 50 is coupled between terminals 70 and 74 of switch 48 and between terminals 78 and 76 of switch 52). Capacitor 50 may have a corresponding capacitance C1.

Filter 38 may further include a third capacitor 54 that couples line 44A to line 44B between the output of switch 52 and the output of filter 38 (e.g., capacitor 54 may have a first electrode or plate coupled to line 44A and a second electrode or plate coupled to line 44B, such that capacitor 54 is coupled between terminals 80 and 82 of switch 52). Capacitor 50 may have capacitance C0.

Switch 48 may have different switch states (modes). Switch 48 may couple its input terminals (e.g., terminals 68 and 72) to different ones of its output terminals (e.g., terminals 70 and 74) in each of the switch states. For example, switch 48 may have a first switch state (sometimes referred to herein as a direct state) in which switch 48 couples terminal 68 to terminal 70 and couples terminal 72 to terminal 74 (e.g., while forming an open circuit between terminal 72 and terminal 70 and an open circuit between terminal 74 and terminal 68). Switch 48 may also have a second switch state (sometimes referred to herein as a crossed state) in which switch 48 couples terminal 68 to terminal 74 and couples terminal 72 to terminal 70 (e.g., while forming an open circuit between terminals 68 and 70 and an open circuit between terminals 72 and 74). Switch 48 may further have a third switch state (sometimes referred to herein as an open circuit state) in which switch 48 forms an open circuit on lines 44A and 44B (e.g., in which switch 48 forms open circuits between terminal 68 and both terminals 70 and 74 and between terminal 72 and both terminals 70 and 74).

Similarly, switch 52 may have different switch states (modes). Switch 52 may couple its input terminals (e.g., terminals 78 and 76) to different ones of its output terminals (e.g., terminals 80 and 82) in each of the switch states. For example, switch 52 may have a first switch state (sometimes referred to herein as a direct state) in which switch 52 couples terminal 78 to terminal 80 and couples terminal 76 to terminal 82 (e.g., while forming an open circuit between terminal 78 and terminal 82 and an open circuit between terminal 76 and terminal 80). Switch 52 may also have a second switch state (sometimes referred to herein as a crossed state) in which switch 52 couples terminal 78 to terminal 82 and couples terminal 76 to terminal 80 (e.g., while forming an open circuit between terminals 78 and 80 and an open circuit between terminals 76 and 82). Switch 52 may further have a third switch state (sometimes referred to herein as an open circuit state) in which switch 52 forms an open circuit on lines 44A and 44B (e.g., in which switch 52 forms open circuits between terminal 78 and both terminals 80 and 82 and between terminal 76 and both terminals 80 and 82).

As one example, switch 48 and switch 52 may be butterfly switches. In this example, switch 48 may, for example, include a first transistor with source/drain terminals coupled between terminals 68 and 70, a second transistor with source/drain terminals coupled between terminals 72 and 74, a third transistor with source/drain terminals coupled between terminals 68 and 74, and a fourth transistor with source/drain terminals coupled between terminals 72 and 70. The gate terminals of the transistors may be controlled to place switch 48 into a selected one of the first, second, and third switch states. Switch 52 may include similar transistors. These examples are illustrative and non-limiting and, in general, switches 48 and 52 may include any desired circuit components to implement at least the first, second, and third switching states.

The clocking circuitry in receiver 31 may provide a clocking signal such as control signal CTRL to switches 48 and 52. Control signal CTRL may place switch 48 into a selected one of the first, second, or third switching states of switch 48 and may place switch 52 into a selected one of the first, second, or third switching states of switch 52. The current switching state of switch 48 and the current switching state of switch 52 may sometimes be referred to collectively herein as the filter state (operating mode) P of filter 38.

Filter 38 may have at least four filter states P such as a first filter state P0, a second filter state P1, a third filter state P3, and a fourth filter state P4. In filter state P0, switch 48 is in the first switch state while switch 52 is concurrently in the third switch state. In filter state P1, switch 48 is in the third switch state while switch 52 is concurrently in the first switch state. In filter state P3, switch 48 is in the second switch state while switch 52 is concurrently in the third switch state. In filter state P4, switch 48 is in the third switch state while switch 52 is concurrently in the second switch state.

Control signal CTRL may control the switch states of switches 48 and 52 (e.g., by providing different voltages to the gate terminals of the different transistors in switches 48 and 52 at different times) to sequentially place filter 38 into filter state P0, then filter state P1, then filter state P3, and then filter state P4 before cycling back to filter state P0. By cycling through filter states P, filter 38 may move charge from output terminals 42 of mixer 36 to output terminals 40 as baseband signals characterized by output voltage Vo, which are then provided to baseband circuitry 26 (FIG. 1) for demodulation/decoding.

For example, when receiving radio-frequency signals, mixer 36 outputs baseband signals at output terminals 42. Charge from the signals is stored on capacitor 46. In filter state P0, switch 48 is in the first switch state. As such, terminal 68 of switch 48 is coupled to terminal 70 and terminal 72 of switch 48 is coupled to terminal 74. This causes the charge to pass from capacitor 46 onto capacitor 50, effectively sharing charge between capacitors 46 and 50 with the same polarity. At the same time, in filter state P0, switch 52 is in the third switch state. This forms an open circuit that prevents charge from passing from capacitor 50 onto capacitor 54 (while capacitor 54 holds its existing charge).

Control signal CTRL may then switch filter 38 to filter state P1. In filter state P1, switch 48 is in the third switch state, forming an open circuit that prevents charge from passing between capacitors 46 and 50. At the same time, in filter state P1, switch 52 is in the first switch state. As such, terminal 78 of switch 52 is coupled to terminal 80 and terminal 76 of switch 52 is coupled to terminal 82. This causes the charge that was stored on capacitor 50 during filter state P0 to flow from capacitor 50 onto capacitor 54, effectively sharing charge between capacitors 50 and 54 with the same polarity.

Control signal CTRL may then switch filter 38 to filter state P3. In filter state P3, switch 48 is in the second switch state. As such, terminal 68 of switch 48 is coupled to terminal 74 and terminal 72 of switch 48 is coupled to terminal 70. This causes the charge stored on capacitor 46 to flow from capacitor 46 onto capacitor 50, effectively sharing charge between capacitors 46 and 50 but with reverse polarity. At the same time, in filter state P3, switch 52 is in the third switch state. This forms an open circuit that prevents charge from passing from capacitor 50 onto capacitor 54 (while capacitor 54 holds its existing charge).

Control signal CTRL may then switch filter 38 to filter state P4. In filter state P4, switch 52 is in the second switch state. As such, terminal 78 of switch 52 is coupled to terminal 82 and terminal 76 of switch 52 is coupled to terminal 80. This causes the charge stored on capacitor 50 to flow from capacitor 50 onto capacitor 54, effectively sharing charge between capacitors 50 and 54 but with reverse polarity. At the same time, in filter state P4, switch 48 is in the third switch state. This forms an open circuit that prevents charge from passing between capacitors 46 and 50. Control signal CTRL may then switch back to filter state P0 and may continue to periodically cycle in sequence from filter state P0 to filter state P1, from filter state P1 to filter state P3, from filter state P3 to filter state P4, and from filter state P4 back to filter state P0 as receiver 31 receives radio-frequency signals. This may allow filter 38 to filter the baseband signals (e.g., by remove aliasing and interference/blocker signals from the baseband signals), which are then provided to baseband circuitry 26 FIG. 1 (e.g., as voltage V_{O} at a baseband frequency f_{BB}).

The example of FIG. 2 in which filter 38 is a second-order filter is illustrative and non-limiting. More generally, filter 38 may be implemented as a second-or-higher order filter (e.g., may be implemented as a third-or-higher order filter by disposing additional stages of switches and capacitors along lines 44A and 44B between switch 52 and output terminals 40 for each higher order). While described herein in connection with reception of radio-frequency signals, mixer 36 and filter 38 may additionally or alternatively be used in a transmitter of device 10 for transmitting radio-frequency signals over antenna 34. If desired, input-output capacitors may be added to filter 38 to provide imaginary axis zeroes to the circuit, which may help to further improve signal rejection. For example, one or more additional capacitors may be coupled between line 44A (e.g., a first output terminal 40) and terminal 80 of switch 52 and/or between line 44B (e.g., a second output terminal 40) and terminal 82 of switch 52.

To minimize aliasing and noise in the (filtered) baseband signals output by filter 38, the timing (clocking) of control signal CTRL may be tightly synchronized to the timing (clocking) of the LO signals LOP and LON provided to mixer 36 by LO generator 64. If desired, receiver 31 may include control signal generation circuitry 66 that receives one or both of LO signals LOP and LON and that generates (clocks) control signal CTRL based on one or both of LO signals LOP and LON. For example, control signal generation circuitry 66 may include divider circuitry that controls the timing of control signals CTRL to periodically pulse in a synchronized manner with LO signals LOP and LON. Control signal generation circuitry 66 may, for example, generate control signals CTRL that serve to periodically switch filter 38 between filter states P after both a single pulse of LO signal LOP and a single pulse of LO signal LON have elapsed. Control signal generation circuitry 66 and LO generator 64 may sometimes be referred to herein collectively as clocking circuitry 65.

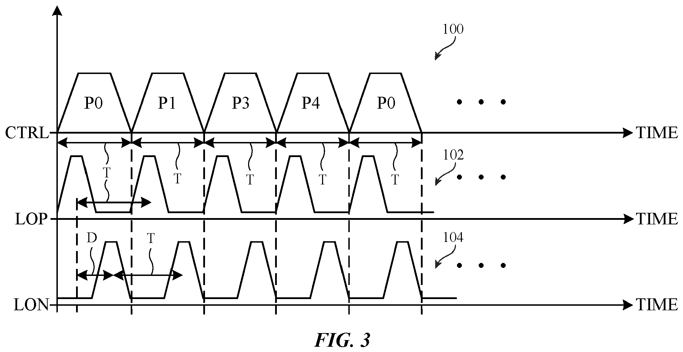

FIG. 3 is a timing diagram showing how the timing of control signal CTRL provided to filter 38 may be synchronized to the timing of LO signals LOP and LON provided to mixer 36. Curve 100 of FIG. 3 plots the timing of control signal CTRL in switching filter 38 between filter states P. As shown by curve 100, control signal CTRL may switch filter 38 to filter state P0 for duration T, may then switch filter 38 from filter state P0 to filter state P1 for another duration T, may then switch filter 38 from filter state P1 to filter state P3 for another duration T, may then switch filter 38 from filter state P3 to filter state P4 for another duration T, may then switch filter 38 back to filter state P0 for another duration T, and may continue to periodically switch through filter states in this way while receiver 31 receives radio-frequency signals.

Curve 102 of FIG. 3 plots the timing of the LO signal LOP provided to transistor 56 in mixer 36. Curve 104 plots the timing of the LO signal LON provided to transistor 58 in mixer 36. As shown by curves 102 and 104, LO signal LOP and LO signal LON may each be sequentially pulsed one time during the duration T of each filter state P (e.g., with timing aligned with the beginning and end of the filter state P). For example, when filter 38 switches to a new filter state, LO signal LOP may be pulsed at the beginning of the corresponding duration T and may remain on for a portion of duration T (e.g., the first half of duration T). LO signal LON may then be pulsed on for the remainder of duration T (e.g., the second half of duration T).

In other words, duration T of each filter state P (e.g., the duration of each pulse of control signal CTRL or the period of control signal CTRL) may be equal to the period of both LO signals LOP and LON, where LO signal LON is phase-shifted or time-delayed by duration D with respect to LO signal LOP (e.g., where duration D is equal to T/2 or a phase offset of 180 degrees). Put differently, the frequency f_{LO} of LO signals LOP and LON may be selected based on the desired frequency to which mixer 36 downconverts the received radio-frequency signals (e.g., the baseband frequency f_{BB} of the baseband signals output by mixer 36 may be equal to f_{RF} - f_{LO}). Control signal generation circuitry 66 may then synchronize the timing of control signal CTRL to frequency f_{LO} such that, given the duration D with which LO signal LON is shifted with respect to LO signal LON, exactly one pulse of LO signal LOP and one pulse of LO signal LON will occur while filter 38 is in each filter state P (e.g., where LO signal LOP is pulsed at the beginning of the filter state P until half of the filter state has elapsed, at which point LO signal LON is pulsed until the end of the filter state). Synchronizing the timing of mixer 36 and filter 38 in this way may allow filter 38 to perform filtering without aliasing, may improve signal rejection relative to lower order filters, consumes no DC power, and exhibits better linearity than when active components are used, for example.

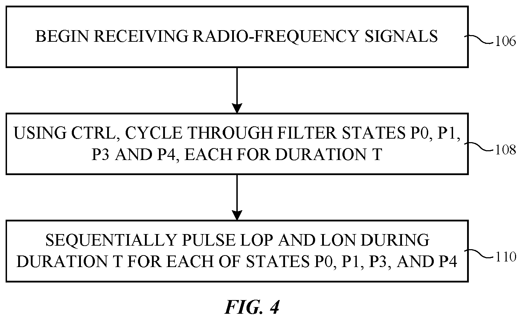

FIG. 4 is a flow chart of operations that may be performed by receiver 31 in receiving radio-frequency signals. At operation 106, receiver 31 may begin receiving radio-frequency signals having input voltage Vᵢ.

At operation 108, control signal generation circuitry 66 may use control signal CTRL to control filter 38 to sequentially cycle through filter states P0, P1, P3, and P4 in that order. Control signal CTRL may control filter 38 to remain in each filter state P for duration T, which may be synchronized with LO signals LOP and LON as shown in FIG. 3. Operation 110 may be performed concurrently with operation 108.

At operation 110, LO generator 64 may sequentially pulse LO signals LOP and LON once during the duration T of each filter state P for filter 38 (e.g., as shown in FIG. 3). LO signals LOP and LON may each have a period equal to duration T, LO signals LOP and LON may be identical but separated in time by duration D, and each pulse of LO signals LOP and LON may last for a duration T/2, for example. The pulsing of LO signals LOP and LON may serve to downconvert the received radio-frequency signals to baseband frequencies. The cycling of filter 38 through filter states P (at operation 108) may move the baseband signals through filter 38 from mixer 36 to output terminals 40 while filtering the signals. Synchronizing the timing of filter states P with the timing of LO signals LOP and LON may minimize aliasing and noise from the signals. The implementation of mixer 36 and filter 38 using passive components (e.g., without active filters, buffers, or amplifiers) may minimize power consumption and may maximize linearity of the signals.

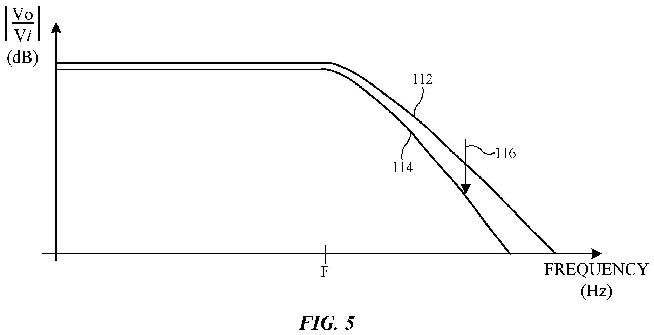

FIG. 5 is a plot of the transfer function of receiver 31 (e.g., the magnitude of output voltage Vo divided by the magnitude of input voltage Vᵢ as a function of frequency, plotted on a logarithmic scale). Curve 112 plots an exemplary transfer function of a voltage mode mixer or current mode mixer with first order filtering. Curve 114 plots an exemplary transfer function of mixer 36 and filter 38 of FIG. 2.

As shown by arrow 116, filter 38 may allow for increased signal rejection at frequencies greater than frequency F relative to implementations without filter 38. At the same time, the transfer function is relatively flat and uniform, indicating minimal droop and group delay. In implementations where filter 38 is a third order filter, the slope of curve 114 beyond frequency F may be as great as 53 dB / 90 MHz, as just one example. The example of FIG. 5 is illustrative and, in practice, curve 114 may have other shapes.

Device 10 may gather and/or use personally identifiable information. It is well understood that the use of personally identifiable information should follow privacy policies and practices that are generally recognized as meeting or exceeding industry or governmental requirements for maintaining the privacy of users. In particular, personally identifiable information data should be managed and handled so as to minimize risks of unintentional or unauthorized access or use, and the nature of authorized use should be clearly indicated to users.

The methods and operations described above in connection with FIGS. 1-5 may be performed by the components of device 10 using software, firmware, and/or hardware (e.g., dedicated circuitry or hardware). Software code for performing these operations may be stored on non-transitory computer readable storage media (e.g., tangible computer readable storage media) stored on one or more of the components of device 10 (e.g., storage circuitry 16 of FIG. 1). The software code may sometimes be referred to as software, data, instructions, program instructions, or code. The non-transitory computer readable storage media may include drives, non-volatile memory such as non-volatile random-access memory (NVRAM), removable flash drives or other removable media, other types of random-access memory, etc. Software stored on the non-transitory computer readable storage media may be executed by processing circuitry on one or more of the components of device 10 (e.g., processing circuitry 18 of FIG. 1, etc.). The processing circuitry may include microprocessors, central processing units (CPUs), application-specific integrated circuits with processing circuitry, or other processing circuitry.

In accordance with an embodiment, a wireless receiver is provided that includes a mixer having a first transistor with a first gate terminal and having a second transistor with a second gate terminal, a filter coupled to an output of the mixer and having switching circuitry with a plurality of states that are selectable based on a control signal and clocking circuitry configured to provide a first LO signal to the first gate terminal, to provide a second LO signal to the second gate terminal, and to synchronize the control signal with the first LO signal and the second LO signal.

In accordance with another embodiment, the first LO signal has a period, the second LO signal has the period, and the second LO signal is offset in time with respect to the first LO signal.

In accordance with another embodiment, the clocking circuitry is configured to place the switching circuitry in each state of the plurality of states for a duration equal to the period.

In accordance with another embodiment, the clocking circuitry is configured to pulse the first LO signal once during each state of the plurality of states and is configured to pulse the second LO signal once during each state of the plurality of states.

In accordance with another embodiment, the second LO signal is offset in time with respect to the first LO signal by half the period.

In accordance with another embodiment, the filter includes a first capacitor coupled between a first output terminal of the mixer and a second output terminal of the mixer, the first transistor being coupled between an input of the mixer and the first output terminal and the second transistor being coupled between the input of the mixer and the second output terminal.

In accordance with another embodiment, the switching circuitry includes a first switch having a first terminal coupled to the first output terminal, a second terminal coupled to the second output terminal, a third terminal, and a fourth terminal and a second switch having a fifth terminal coupled to the third terminal, a sixth terminal coupled to the fourth terminal, a seventh terminal coupled to an output of the filter, and an eighth terminal coupled to the output of the filter.

In accordance with another embodiment, the filter includes a second capacitor coupled between the third terminal and the fourth terminal and a third capacitor coupled between the seventh terminal and the eighth terminal.

In accordance with another embodiment, the plurality of states includes a first state, a second state, a third state, and a fourth state, the second switch forms an open circuit between the second and third capacitors in the first and third states, and the first switch forms an open circuit between the first and second capacitors in the second and fourth states.

In accordance with another embodiment, the first switch couples the first terminal to the third terminal and couples the second terminal to the fourth terminal in the first state, the first switch couples the first terminal to the fourth terminal and couples the second terminal to the third terminal in the third state, the second switch couples the fifth terminal to the seventh terminal and couples the sixth terminal to the eighth terminal in the second state, and the second switch couples the fifth terminal to the eighth terminal and couples the sixth terminal to the seventh terminal in the fourth state.

In accordance with another embodiment, the first LO signal has a period, the second LO signal has the period, and the second LO signal is offset in time with respect to the first LO signal, the clocking circuitry is configured to place the switching circuitry in each of the first, second, third, and fourth states for a duration equal to the period, the clocking circuitry is configured to pulse the first LO signal only once during each of the first, second, third, and fourth states, and the clocking circuitry is configured to pulse the second LO signal only once during each of the first, second, third, and fourth states.

In accordance with another embodiment, the mixer is a passive mixer and the filter includes a first line directly connected to a first output terminal of the mixer, a second line directly connected to a second output terminal of the mixer, at least three capacitors coupled between the first and second lines and at least two butterfly switches disposed on the first and second lines.

In accordance with an embodiment, an electronic device is provided that includes an antenna, a radio-frequency transmission line path coupled to the antenna, a passive voltage mode mixer having an input coupled to the radio-frequency transmission line path and having an output and a second-or-higher order passive switched-capacitor filter having an input coupled to the output of the passive voltage mode mixer.

In accordance with another embodiment, the output of the passive voltage mode mixer includes a first output terminal and a second output terminal, the passive voltage mode mixer further includes a first transistor coupled between the radio-frequency transmission line path and the first output terminal, a second transistor coupled between the radio-frequency transmission line and the second output terminal, a first capacitor coupled between the first output terminal and a reference potential and a second capacitor coupled between the second output terminal and the reference potential.

In accordance with another embodiment, the second-or-higher order passive switched-capacitor filter includes a first line coupled to the first output terminal, a second line coupled to the second output terminal, a third capacitor coupled between the first and second lines and a first butterfly switch disposed on the first and second lines and having a first terminal coupled to the first output terminal and the third capacitor, a second terminal coupled to the second output terminal and the third capacitor, a third terminal on the first line, and a fourth terminal on the second line.

In accordance with another embodiment, the second-or-higher order passive switched-capacitor filter includes a second butterfly switch disposed on the first and second lines and having a fifth terminal coupled to the third terminal, a sixth terminal coupled to the fourth terminal, a seventh terminal on the first line, and an eighth terminal on the second line, a fourth capacitor coupled between the first and second lines between the first and second butterfly switches and a fifth capacitor coupled between the first and second lines and between the seventh and eighth terminals.

In accordance with another embodiment, the electronic device includes clocking circuitry, the clocking circuitry is configured to provide pulses of a control signal having a period to the second-or-higher order passive switched-capacitor filter, the clocking circuitry is configured to provide a first local oscillator (LO) signal and a second LO signal to the passive voltage mode mixer, the first LO signal and the second LO signal have the period, the second LO signal is offset in time with respect to the first LO signal by half the period, and the clocking circuitry is configured to pulse the first LO signal and the second LO signal once during each pulse of the control signal.

In accordance with an embodiment, a method of using a wireless receiver to receive radio-frequency signals, the method is provided that includes with a passive mixer, downconverting the radio-frequency signals based on a first local oscillator (LO) signal and a second LO signal to generate baseband signals, the second LO signal being offset in time with respect to the first LO signal, with a passive switched-capacitor filter, filtering the baseband signals based on a control signal that switches the passive switched-capacitor filter between a series of states, with clocking circuitry, pulsing the first LO signal once while the passive switched-capacitor filter is in each state of the series of states and with the clocking circuitry, pulsing the second LO signal once while the passive switched-capacitor filter is in each state of the series of states.

In accordance with another embodiment, the passive switched-capacitor filter is in each state of the series of states for a duration, the first LO signal has a period equal to the duration, and the second LO signal has the period equal to the duration.

In accordance with another embodiment, the second LO signal is offset from the first LO signal by half the duration.

The foregoing is merely illustrative and various modifications can be made to the described embodiments. The foregoing embodiments may be implemented individually or in any combination.

Exemplary embodiments of the present disclosure are set out in the following items:
1. A wireless receiver comprising:
   a mixer having a first transistor with a first gate terminal and having a second transistor with a second gate terminal;
   a filter coupled to an output of the mixer and having switching circuitry with a plurality of states that are selectable based on a control signal; and
   clocking circuitry configured to provide a first LO signal to the first gate terminal, to provide a second LO signal to the second gate terminal, and to synchronize the control signal with the first LO signal and the second LO signal.
2. The wireless receiver of item 1, wherein the first LO signal has a period, the second LO signal has the period, and the second LO signal is offset in time with respect to the first LO signal.
3. The wireless receiver of item 2, wherein the clocking circuitry is configured to place the switching circuitry in each state of the plurality of states for a duration equal to the period.
4. The wireless receiver of item 3 wherein the clocking circuitry is configured to pulse the first LO signal once during each state of the plurality of states and is configured to pulse the second LO signal once during each state of the plurality of states.
5. The wireless receiver of item 4, wherein the second LO signal is offset in time with respect to the first LO signal by half the period.
6. The wireless receiver of any of items 1-5, wherein the filter comprises:
   a first capacitor coupled between a first output terminal of the mixer and a second output terminal of the mixer, the first transistor being coupled between an input of the mixer and the first output terminal and the second transistor being coupled between the input of the mixer and the second output terminal.
7. The wireless receiver of item 6, wherein the switching circuitry comprises:
   a first switch having a first terminal coupled to the first output terminal, a second terminal coupled to the second output terminal, a third terminal, and a fourth terminal; and
   a second switch having a fifth terminal coupled to the third terminal, a sixth terminal coupled to the fourth terminal, a seventh terminal coupled to an output of the filter, and an eighth terminal coupled to the output of the filter.
8. The wireless receiver of item 7, wherein the filter comprises:
   a second capacitor coupled between the third terminal and the fourth terminal; and
   a third capacitor coupled between the seventh terminal and the eighth terminal.
9. The wireless receiver of item 8, wherein the plurality of states comprises a first state, a second state, a third state, and a fourth state, the second switch forms an open circuit between the second and third capacitors in the first and third states, and the first switch forms an open circuit between the first and second capacitors in the second and fourth states.
10. The wireless receiver of item 9, wherein the first switch couples the first terminal to the third terminal and couples the second terminal to the fourth terminal in the first state, the first switch couples the first terminal to the fourth terminal and couples the second terminal to the third terminal in the third state, the second switch couples the fifth terminal to the seventh terminal and couples the sixth terminal to the eighth terminal in the second state, and the second switch couples the fifth terminal to the eighth terminal and couples the sixth terminal to the seventh terminal in the fourth state.
11. The wireless receiver of item 10, wherein the first LO signal has a period, the second LO signal has the period, and the second LO signal is offset in time with respect to the first LO signal, the clocking circuitry is configured to place the switching circuitry in each of the first, second, third, and fourth states for a duration equal to the period, the clocking circuitry is configured to pulse the first LO signal only once during each of the first, second, third, and fourth states, and the clocking circuitry is configured to pulse the second LO signal only once during each of the first, second, third, and fourth states.
12. The wireless receiver of any of items 1-11, wherein the mixer is a passive mixer and the filter comprises:
   a first line directly connected to a first output terminal of the mixer;
   a second line directly connected to a second output terminal of the mixer;
   at least three capacitors coupled between the first and second lines; and
   at least two butterfly switches disposed on the first and second lines.
13. An electronic device comprising:
   an antenna;
   a radio-frequency transmission line path coupled to the antenna;
   a passive voltage mode mixer having an input coupled to the radio-frequency transmission line path and having an output; and
   a second-or-higher order passive switched-capacitor filter having an input coupled to the output of the passive voltage mode mixer.
14. The electronic device of item 13, wherein the output of the passive voltage mode mixer comprises a first output terminal and a second output terminal, the passive voltage mode mixer further comprising:
   a first transistor coupled between the radio-frequency transmission line path and the first output terminal;
   a second transistor coupled between the radio-frequency transmission line and the second output terminal;
   a first capacitor coupled between the first output terminal and a reference potential; and
   a second capacitor coupled between the second output terminal and the reference potential.
15. The electronic device of item 14, wherein the second-or-higher order passive switched-capacitor filter comprises:
   a first line coupled to the first output terminal;
   a second line coupled to the second output terminal;
   a third capacitor coupled between the first and second lines; and
   a first butterfly switch disposed on the first and second lines and having a first terminal coupled to the first output terminal and the third capacitor, a second terminal coupled to the second output terminal and the third capacitor, a third terminal on the first line, and a fourth terminal on the second line.
16. The electronic device of item 15, wherein the second-or-higher order passive switched-capacitor filter comprises:
   a second butterfly switch disposed on the first and second lines and having a fifth terminal coupled to the third terminal, a sixth terminal coupled to the fourth terminal, a seventh terminal on the first line, and an eighth terminal on the second line;
   a fourth capacitor coupled between the first and second lines between the first and second butterfly switches; and
   a fifth capacitor coupled between the first and second lines and between the seventh and eighth terminals.
17. The electronic device of any of items 13-16, further comprising:
   clocking circuitry, wherein
   the clocking circuitry is configured to provide pulses of a control signal having a period to the second-or-higher order passive switched-capacitor filter,
   the clocking circuitry is configured to provide a first local oscillator (LO) signal and a second LO signal to the passive voltage mode mixer,
   the first LO signal and the second LO signal have the period,
   the second LO signal is offset in time with respect to the first LO signal by half the period, and
   the clocking circuitry is configured to pulse the first LO signal and the second LO signal once during each pulse of the control signal.
18. A method of using a wireless receiver to receive radio-frequency signals, the method comprising:
   with a passive mixer, downconverting the radio-frequency signals based on a first local oscillator (LO) signal and a second LO signal to generate baseband signals, the second LO signal being offset in time with respect to the first LO signal;
   with a passive switched-capacitor filter, filtering the baseband signals based on a control signal that switches the passive switched-capacitor filter between a series of states;
   with clocking circuitry, pulsing the first LO signal once while the passive switched-capacitor filter is in each state of the series of states; and
   with the clocking circuitry, pulsing the second LO signal once while the passive switched-capacitor filter is in each state of the series of states.
19. The method of item 18, wherein the passive switched-capacitor filter is in each state of the series of states for a duration, the first LO signal has a period equal to the duration, and the second LO signal has the period equal to the duration.
20. The method of item 19, wherein the second LO signal is offset from the first LO signal by half the duration.

## Claims

1. A wireless receiver comprising:
a mixer having a first transistor with a first gate terminal and having a second transistor with a second gate terminal;
a filter coupled to an output of the mixer and having switching circuitry with a plurality of states that are selectable based on a control signal; and
clocking circuitry configured to provide a first LO signal to the first gate terminal, to provide a second LO signal to the second gate terminal, and to synchronize the control signal with the first LO signal and the second LO signal.

2. The wireless receiver of claim 1, wherein the first LO signal has a period, the second LO signal has the period, and the second LO signal is offset in time with respect to the first LO signal.

3. The wireless receiver of claim 2, wherein the clocking circuitry is configured to place the switching circuitry in each state of the plurality of states for a duration equal to the period.

4. The wireless receiver of claim 3 wherein the clocking circuitry is configured to pulse the first LO signal once during each state of the plurality of states and is configured to pulse the second LO signal once during each state of the plurality of states.

5. The wireless receiver of claim 4, wherein the second LO signal is offset in time with respect to the first LO signal by half the period.

6. The wireless receiver of any of claims 1-5, wherein the filter comprises:
a first capacitor coupled between a first output terminal of the mixer and a second output terminal of the mixer, the first transistor being coupled between an input of the mixer and the first output terminal and the second transistor being coupled between the input of the mixer and the second output terminal.

7. The wireless receiver of claim 6, wherein the switching circuitry comprises:
a first switch having a first terminal coupled to the first output terminal, a second terminal coupled to the second output terminal, a third terminal, and a fourth terminal; and
a second switch having a fifth terminal coupled to the third terminal, a sixth terminal coupled to the fourth terminal, a seventh terminal coupled to an output of the filter, and an eighth terminal coupled to the output of the filter.

8. The wireless receiver of claim 7, wherein the filter comprises:
a second capacitor coupled between the third terminal and the fourth terminal; and
a third capacitor coupled between the seventh terminal and the eighth terminal.

9. The wireless receiver of claim 8, wherein the plurality of states comprises a first state, a second state, a third state, and a fourth state, the second switch forms an open circuit between the second and third capacitors in the first and third states, and the first switch forms an open circuit between the first and second capacitors in the second and fourth states.

10. The wireless receiver of claim 9, wherein the first switch couples the first terminal to the third terminal and couples the second terminal to the fourth terminal in the first state, the first switch couples the first terminal to the fourth terminal and couples the second terminal to the third terminal in the third state, the second switch couples the fifth terminal to the seventh terminal and couples the sixth terminal to the eighth terminal in the second state, and the second switch couples the fifth terminal to the eighth terminal and couples the sixth terminal to the seventh terminal in the fourth state.

11. The wireless receiver of claim 10, wherein the first LO signal has a period, the second LO signal has the period, and the second LO signal is offset in time with respect to the first LO signal, the clocking circuitry is configured to place the switching circuitry in each of the first, second, third, and fourth states for a duration equal to the period, the clocking circuitry is configured to pulse the first LO signal only once during each of the first, second, third, and fourth states, and the clocking circuitry is configured to pulse the second LO signal only once during each of the first, second, third, and fourth states.

12. The wireless receiver of any of claims 1-11, wherein the mixer is a passive mixer and the filter comprises:
a first line directly connected to a first output terminal of the mixer;
a second line directly connected to a second output terminal of the mixer;
at least three capacitors coupled between the first and second lines; and
at least two butterfly switches disposed on the first and second lines.

13. A method of using a wireless receiver to receive radio-frequency signals, the method comprising:
with a passive mixer, downconverting the radio-frequency signals based on a first local oscillator (LO) signal and a second LO signal to generate baseband signals, the second LO signal being offset in time with respect to the first LO signal;
with a passive switched-capacitor filter, filtering the baseband signals based on a control signal that switches the passive switched-capacitor filter between a series of states;
with clocking circuitry, pulsing the first LO signal once while the passive switched-capacitor filter is in each state of the series of states; and
with the clocking circuitry, pulsing the second LO signal once while the passive switched-capacitor filter is in each state of the series of states.

14. The method of claim 13, wherein the passive switched-capacitor filter is in each state of the series of states for a duration, the first LO signal has a period equal to the duration, and the second LO signal has the period equal to the duration.

15. The method of claim 14, wherein the second LO signal is offset from the first LO signal by half the duration.
